# EUROPEAN PATENT SPECIFICATION

(11) **EP 4 581 659 B1**
(45) Date of publication and mention of the grant of the patent: **10.12.2025**
(21) Application number: 23757973.5
(22) Date of filing: 28.08.2023
(51) Int. Cl.: H01J 37/20, H01J 37/28

(54) **CHARGED-PARTICLE IRRADIATION UNIT FOR A DIFFRACTOMETER**
LADUNGSTEILCHEN-BESTRAHLUNGSEINHEIT FÜR EIN DIFFRAKTOMETER
UNITÉ D'IRRADIATION PAR PARTICULES CHARGÉES POUR UN DIFFRACTOMÈTRE

(30) Priority: 29.08.2022 EP 22192609
(43) Date of publication of application: 09.07.2025
(73) Proprietor: Eldico Scientific AG, 4123 Allschwil (CH)
(72) Inventor: GARBUGLIA, Francesco, 4123 Allschwil (CH)
(74) Representative: Bohest AG
(86) International application number: PCT/EP2023/073546
(87) International publication number: WO 2024/046987

(56) References cited:
- US-A1- 2011 253 905
- US-A1- 2022 238 299

## Description

### FIELD OF THE INVENTION

The present invention relates to a charged-particle irradiation unit for a charged-particle diffractometer. The invention further relates to a charged-particle diffractometer comprising such a charged-particle irradiation unit, wherein the diffractometer may be preferably used for charged-particle crystallography of a crystalline sample, in particular for electron crystallography of a crystalline sample.

### BACKGROUND OF THE INVENTION

Crystallography is an essential technology in most fields of chemistry, in particular for structure determination of crystalline samples. For many decades, X-ray diffraction analysis has been the main technology for structure determination. However, X-ray diffraction analysis requires large and well-ordered crystals to withstand the negative effects of radiation damage during irradiation and data collection. For analyzing smaller samples, in particular those which are difficult to be grown to a sufficiently large size, it has been proposed to use charged-particles, such as electrons, for structure determination. In contrast to X-ray diffraction, charged-particle diffraction imposes virtually no lower size limit to the crystal. For example, using a beam of accelerated electrons allows for recording diffraction patterns of nano-crystalline samples having a diameter of less than one micrometer down to several nanometers.

Typically, electron diffraction analysis is performed in standard electron microscopes, in particular transmission electron microscopes (TEM). For this, the crystalline sample is mounted to a sample holder within the sample chamber of the microscope. An electron source of the microscope generates a beam of energetic electrons which subsequently is manipulated (deflected and/or focused) by electron-optical elements (electron lenses, deflectors, and/or multi-poles) such as to irradiate the sample mounted to the sample holder. The sample holder may allow for positioning the sample relative to the beam axis along different translational degrees of freedom as well as a rotational degree of freedom. The rotational degree of freedom is used to tilt the sample holder around a rotation axis with respect to the incident electron beam, thus allowing to acquire a tilt series of diffraction patterns by irradiating the sample at different tilt angles (rotational positions) and collecting for each rotational position the electrons transmitted through the sample using an electron imaging system. Finally, the images of the tilt series are aligned with respect to each other in order to reconstruct a three-dimensional electron diffraction data set of the crystalline sample. This procedure is often denoted as electron diffraction tomography and described, for example, in EP 2 402 976 A1 or in Shi et al., eLife 2013, e01345, DOI: 10.7554/eLife.01345.

Due to the small beam size and due to the small sample sizes, the volume-of-interest, that is, the sample volume may be displaced from the beam axis when changing the tilt angle to another rotational position. This displacement may in particular occur if the sample is arranged off-center with respect to the rotation axis. Accordingly, repositioning of the sample at least in a direction that is perpendicular to the beam axis and perpendicular to the rotation axis may be required for each image of the tilt series. However, this procedure may be laborious and time-consuming, if possible at all.

Therefore, it is an object of the present invention to provide a charged-particle irradiation unit for a charged-particle diffractometer with the advantages of prior art solutions whilst mitigating their limitations. In particular, it is an object of the present invention to provide a charged-particle irradiation unit for a charged-particle diffractometer which allows for a more stable positioning of the sample with regard to the charged-particle beam, in particular which requires less repositioning and - if required - preferably even allows for an automatic repositioning of the sample relative to the charged-particle beam.

### DESCRIPTION OF THE INVENTION

These and other objects are met by a charged-particle irradiation unit for a charged-particle diffractometer as specified in the independent claim. Advantageous embodiments of the charged-particle irradiation unit according to the invention are the subject of the dependent claims.

According to the invention there is provided a charged-particle irradiation unit for a charged-particle diffractometer, which comprises a charged-particle source for generating a charged-particle beam along a charged-particle beam axis, wherein the beam axis extends in a substantially horizontal direction. The irradiation unit further comprises a charged-particle-optical system for manipulating the charged-particle beam such as to irradiate the sample with the charged-particle beam. In addition, the irradiation unit comprises a sample holder for holding the sample as well as a manipulator operatively coupled to the sample holder for positioning the sample relative to the beam axis. The manipulator comprises:
- a rotation stage for rotating (tilting) the sample holder with respect to the incident charged-particle beam around a rotation axis over different rotational positions, the rotation axis extending in a substantially vertical direction,
- a first translation stage configured to move the sample holder at least along a first sample axis and a second sample axis in a plane substantially perpendicular to the rotation axis, wherein first translation stage is operatively coupled between the sample holder and the rotation stage such that the first translation stage is in a rotational system of the rotation stage and the sample holder is in a moving system of the first translation stage, thereby enabling to position the center of mass of the sample substantially on-axis with regard to the rotation axis; and
- a second translation stage configured to move the rotation stage, the sample holder and the first translation stage at least along a first manipulator axis that is perpendicular to the beam axis and perpendicular to the vertical direction, wherein the rotation stage is operatively coupled between the second translation stage and the first translation stage such that the rotation stage is in a moving system of the second translation stage, thereby enabling to compensate for different rotational positions of the rotation stage a respective measured or pre-determined native deviation of the rotation axis from a position of a nominal reference rotation axis of the rotation stage at least in a direction that is perpendicular to the beam axis and perpendicular to the vertical direction.

According to the invention, it has been found that if the rotation axis of the rotation stage is arranged to extend in a substantially vertical direction, any gravitational effects on the rotation axis, the sample holder and the sample are the same for each rotational position. Advantageously, this facilitates to reduce gravitation-induced variations of the rotation axis position (orientation) between different rotational positions. Thus, a vertical orientation of the rotation axis may improve the positional stability of the sample holder and the sample over the entire rotation angle range. A vertical orientation of the rotation axis may also prove advantageous with regard to an operation at cryogenic temperatures. **In** particular, the vertical orientation of the rotation axis allows to attach a cryogenic cooling source to the manipulator in an upright position.

With regard to a vertical arrangement of the rotation axis, the manipulator may be arranged either vertically above or vertically below the sample holder.

**In** addition, it has been found that a stable positioning of the sample relative to the charged-particle beam over different rotational positions is improved on the one hand by avoiding an off-centric arrangement of the sample with respect to the rotation axis and on the other hand by providing the possibility to compensate a possible native deviation (offset and inclination) of the rotation axis from a position of a nominal reference rotation axis of the rotation stage occurring for different rotational positions of the rotation stage.

Accordingly to the invention, correction of a possible off-centric arrangement of the sample with respect to the rotation axis is accomplished by the first translation stage which is operatively coupled between the sample holder and the rotation stage and allows to move the sample holder at least in a plane perpendicular to the rotation axis and, thus, to exactly position the sample, that is, its center of mass, on-axis with regard to the rotation axis. Accordingly, due to the on-axis position, the sample does not revolve in a circle around the rotation axis when changing the rotational position (tilt angle). Instead, the translational position of the center of mass of the sample is substantially stable within a plane perpendicular to the rotation axis. Thus, once the charged-particle beam is focused onto the on-axis position of the sample, the volume-of-interest, that is, the sample volume substantially stays within the charged-particle beam for each rotational position (tilt angle) of the rotation stage. Accordingly, the center of mass of the sample advantageously needs to be aligned to the rotation axis only once prior to taking diffraction patterns for different rotational positions (tilt angles). Thus, re-alignment of the sample each time the tilt angle is changed is not necessary any longer.

According to the invention it has been further found that even though the sample may be perfectly aligned on-axis with regard to the rotation axis, the effective rotation axis of the rotation stage may deviate from the position of a nominal reference rotation axis in terms of a lateral and/or parallel offset and/or in terms of an inclination. In particular, these deviations may occur to varying degrees at different rotational positions of the rotation stage, thus causing the position of the sample relative to the beam to vary across different rotational position. In the worst case, the sample may get out of the beam for certain rotational positions. Such deviations may be mainly due to manufacturing tolerances, in particular due to fitting inaccuracies and an imperfect pivot bearing between the rotating part and the stationary part of the rotation station. As the deviations are mainly related to the manufacturing, they are denoted as native deviation herein. In general, the imperfections can cause the effective rotation axis to have different lateral and parallel offsets and/or inclinations relative to the position of a nominal reference rotation axis at different rotational positions of the rotation stage.

According to the invention, it has been identified that lateral horizontal offsets perpendicular to the beam axis have a major effect on the position accuracy of the sample relative to the substantially horizontal charged-particle beam over different rotational positions. In contrast, the effects of parallel offsets in the vertical direction (vertical travel), lateral offsets along the beam axis and inclinations of the effective rotation axis relative to the vertical direction are less severe. Accordingly, it has been found that it may be sufficient to compensate mainly lateral offsets of the effective rotation axis in a direction perpendicular to the beam axis and perpendicular to the rotation axis. For this reason, the manipulator according to the present invention comprises a translation stage which is configured to move the rotation stage, the sample holder and the first translation stage at least along a first manipulator axis that is perpendicular to the beam axis and perpendicular to the vertical rotation axis.

Advantageously, this helps to ensure that the volume of the sample substantially stays within the charged-particle beam for different rotational positions of the rotation stage.

Preferably, the manipulator, in particular the first and the second translational stages, is configured such as to allow a positioning accuracy of the center of mass of the sample relative to the rotation axis with a maximum lateral deviation from the rotation axis of at most 1 µm, in particular of at most 0.5 µm, preferably of at most 0.3 µm, even more preferably of at most 0.1 µm.

**In** addition to the first manipulator axis, the second translation stage may be further configured to move the rotation stage, the sample holder and the first translation stage along a second manipulator axis that is perpendicular to the beam axis and perpendicular to the first manipulator axis, i.e. along a second manipulator axis which is substantially parallel to the vertical direction. Due to this, the second translation stage may be additionally able to compensate over different rotational positions also parallel offsets (vertical travel) of the effective rotation axis, that is, deviations in a direction that is perpendicular to the beam axis and perpendicular to the first manipulator axis, in other words substantially vertical deviations of the rotational axis. In total, the second translation stage may thus be able to compensate for different rotational positions of the rotation stage a respective measured or pre-determined native deviation of the rotation axis at least in a plane perpendicular to the beam axis.

Finally, the second translation stage may be further configured to move the rotation stage, the sample holder and the first translation stage along a third manipulator axis substantially parallel to the beam axis. This further allows to compensate for deviations of the effective rotation axis along the beam axis, in particular to adjust the entire sample along the beam axis relative to the charged particle-optical system and the charged-particle source.

Likewise, the first translation stage may be further configured move the sample holder (in addition to the movement in the plane perpendicular to the rotation axis along the first and second sample axes) along a third sample axis, perpendicular to the first sample axis and perpendicular to the second sample axis. Advantageously, this further enhances the possibility to correctly align the sample with the charged particle beam, in particular to adjust the sample in the vertical direction.

Preferably, the irradiation unit comprises a controller operatively coupled to the manipulator to control movement of the rotation stage, the first translation stage and the second translation stage along the various axes, i.e. the rotation axis, the first and second sample axis and - if present - the third sample axis, as well as the first manipulator axis and - if present - the second and third manipulator axis, respectively. Advantageously, the controller enables an automatic and remote control of the sample positioning.

In particular, the controller may be configured to control movement of the second translation stage along at least the first manipulator axis based on the measured or pre-determined native deviation of the rotation axis such as to compensate for different rotational positions of the rotation stage the respective native deviation of the rotation axis from the position of the nominal reference rotation axis at least in a direction that is perpendicular to the beam axis and perpendicular to the vertical direction.

Likewise, the controller may be further configured to control movement of the second translation stage along the second manipulator axis (in addition to the movement along the first manipulator axis). In particular, the controller may be configured to control movement of the second translation stage along the second manipulator axis (in addition to the movement along the first manipulator axis) based on the measured pre-determined native deviation of the rotation axis such as to compensate for different rotational positions of the rotation stage the respective native deviation of the rotation axis from the position of the nominal reference rotation axis at least in a plane perpendicular to the beam axis.

Moreover, the controller may be configured to control movement of the second translation stage also along the third manipulator axis (in particular in addition to the movement along the first and second manipulator axes). In particular, the controller may be configured to control movement of the second translation stage along the third manipulator axis (in particular in addition to the movement along the first and second manipulator axes) based on the measured pre-determined native deviation of the rotation axis such as to compensate for different rotational positions of the rotation stage the respective native deviation of the rotation axis from the position of the nominal reference rotation axis in three dimensions.

Advantageously, the more axes of the second translation stage are controlled by controller, in particular based on the respective measured or pre-determined native deviations, the better the position stability of the sample over different rotational positions.

Preferably, the rotation stage is configured to determine the rotational position of the rotation stage itself. For example, the rotation stage may comprise an encoder for determining the rotational position of the rotation stage.

In order to enable a proper compensation of the deviation for the respective rotational position, the controller may be operatively coupled to the rotation stage to receive the determined rotational position of the rotation stage. For example, the rotation stage may be configured to generate a signal indicative of the actual rotational position of the rotation stage. The signal may be received by the controller.

In addition, the first translation stage may also be configured to determine the position of the first translation stage along the first sample axis and the second sample axis and preferably the third sample axis (if present), in particular to generate a signal indicative of the actual position of the first translation stage along the first sample axis and the second sample axis. Likewise, the second translation stage may be configured to determine the position of the second translation stage along the first manipulator axis and preferably also along at least one of the second manipulator axis and the third manipulator axis. In particular, the second translation stage may be configured to generate a signal indicative of the actual position of the second translation stage along the first manipulator axis and preferably also along at least one of the second manipulator axis and the third manipulator axis. To communicate the respective signals generated by the first translation stage and the second translation stage to the controller, the controller may be operatively coupled to the first translation stage and the second translation stage, respectively.

For determining the respective axis positions or rotational positions, each one of the first and the second translation stage and the rotation stage may comprise a measurement device, such as an encoder, in particular one or more capacitive position sensors. Preferably, each one of the first and the second translation stage comprises a measurement device, in particular a capacitive position sensor for each of its translation axis, that is, for the first and second sample axis and - if present - the third sample axis, and for the first manipulator axis and - if present - the second and third manipulator axis, respectively. This enables to measure a position of the sample holder and thus of the sample relative to the reference system of the particle beam via a chain of position measurements for the various axes of the manipulator.

As mentioned above, the native deviation may be either pre-determined or measured. In the first case, the controller may comprise a storage for storing the respective pre-determined native deviation of the rotation axis for different rotational positions of the rotation stage. The pre-determined native deviations may be stored in the form of a lookup table which contains for each axis, in particular for the first manipulator axis and preferably also for the second manipulator axis and the third manipulator axis, the respective native deviations of the rotation axis along these axes for different rotational positions. The respective values of the deviations along the different axes for different rotational positions may be converted into respective control signals or may correspond to respective (converted) control signals to the second translation stage, wherein the control signals are indicative of the respective correction movement (displacement/shift) of the second translation stage along the first manipulator axis, and preferably also along the second manipulator axis and the third manipulator axis, required at a given rotational position of the rotation stage in order to compensate the respective deviation of the rotation axis at this rotational position.

Where the compensation is based on measured deviations, the irradiation unit may comprise a measurement device, in particular a measurement device including one or more capacitive position sensors or an interferometric measurement device, for measuring for different rotational positions, in particular for each rotational position of the rotation stage, the respective native deviation of the rotation axis from the position of the nominal reference rotation axis at least in a direction that is perpendicular to the beam axis and perpendicular to the vertical direction, that is, along the direction of the first manipulator axis.

Preferably, the measurement device also is configured to additionally measure for different rotational positions, in particular for each rotational position of the rotation stage, the respective native deviation of the rotation axis from the position of the nominal reference rotation axis in a direction perpendicular to the beam axis and perpendicular to the first manipulator axis, that is, along the second manipulator axis. Likewise, the measurement device may be configured to additionally measure for different rotational positions, in particular for each rotational position of the rotation stage, the respective native deviation of the rotation axis from the position of the nominal reference rotation axis in a direction substantially parallel to the beam axis, that is, along the third manipulator axis. In this case, the measurement is configured to measure the deviation of the rotation axis in three dimensions, that is along the first, the second and the third manipulator axis.

The measurement device may be configured to generate a signal indicative of the respective measured native deviation of the rotation axis from the position of the nominal reference rotation axis.

The measurement of the deviations may be realized in different ways. For example, the rotation stage may comprise a cylindrical reference surface aligned substantially coaxial with the rotation axis, wherein a position of a cylinder axis of the cylindrical reference surface at a pre-defined rotational reference position of the rotation stage may define the position of the nominal reference rotation axis. More specifically, the rotation stage may comprise a cylindrical reference body aligned substantially coaxial with the rotation axis, wherein an outer surface of the cylindrical reference body defines the cylindrical reference surface. The cylindrical reference surface is itself rotationally symmetric. Hence, besides invariant rotational position changes, any position deviation of the cylindrical reference surface from its position at the pre-defined rotational reference position, in particular a lateral shift in the horizontal plane and/or inclinations of the cylindrical reference surface relative to vertical direction, possibly occurring at any rotational position other than the pre-defined rotational reference position, indicate a deviation of the rotation axis from the position of the nominal reference rotation axis at that position. Such position deviations of the cylindrical reference surface may be measured, for example, by capacitive position sensors, wherein preferably at least one sensor is provided to measure a position deviation of the cylindrical reference surface in a direction along each of the three manipulator axes of the second translation stage. The sensors may be configured to generate a signal indicative of the respective measured native deviation of the rotation axis from the position of the nominal reference rotation axis along the respective manipulator axis. The signal may be subsequently used by the controller to correct the position of the rotation stage along at least the first manipulator axis, and preferably also along the second and the third manipulator axes. In particular, this kind of compensation can be realized as a feedback control

The cylindrical reference body may be attached to the rotating part of the rotation stage. As a matter of principle, attaching the cylindrical reference body to the rotating part of the rotation stage may be subject to imperfections, that is, the cylindrical axis of the cylindrical reference body may not be perfectly aligned coaxially with the actual axis of rotation around which the rotating part of the rotation stage rotates relative to the stationary part of the rotation stage. Any misalignments of the cylindrical reference body relative to the rotating part of the rotation stage may be pre-determined prior to installing the rotation stage and may be considered in the measurement of the deviations of the effective rotation axis from the position of the nominal reference rotation axis.

In order to compensate the measured deviations during operation of the irradiation unit, the controller preferably is operatively coupled to the measurement device in order to receive the respective measured native deviations of the rotation axis from the position of the nominal reference rotation axis, in particular to receive a signal indicative of the respective measured native deviations of the rotation axis from the position of the nominal reference rotation axis.

The manipulator or at least parts thereof, in particular at least the first translation stage and preferably also the rotation stage and the second translation stage, may be arranged within a sample chamber of the irradiation unit. The sample chamber may also be a sample chamber of the diffractometer, the irradiation unit is to be used in, or at least a part thereof. Like in electron microscopy, the sample chamber contains the sample holder and the sample. Preferably, the sample chamber is configured for vacuum operation. That is, the interior of the sample chamber may be evacuated or evacuatable to suppress undesired interaction of the charged-particle beam with any matter other than the sample. Having the manipulator or at least parts thereof arranged within the sample chamber also proves advantageous with regard to a compact design of the manipulator.

The rotation stage may be configured to rotate (tilt) the sample holder over an angular range between +70° and -70°, in particular between +250° and -70°, or between -250° and +70°, preferably between +360° and -360°. The given rotational positions are measured with regard to a reference plane which contains the beam axis and which is parallel to the rotation axis. An angular range between +70° and -70°, in particular between +250° and -70° or between -250° and +70° advantageously allows for an unrestricted or mostly unrestricted irradiation of the sample without having the incident charged-particle beam to collide with the sample holder.

The irradiation unit may be configured to allow measuring a tilt series of diffraction patterns in a continuous tilting mode. In this mode, the rotational position (tilt angle) is continuously changed while acquiring a series of diffraction patterns. Advantageously, measuring in a continuous tilting mode significantly reduces the time for data acquisition. In particular, the continuous tilting mode does not require to wait after having changed to another rotational position until vibrations, e.g. due to rotationally acceleration, have damped out and until the position of the sample holder has stabilized. According to this aspect, the rotation stage may be configured to rotate (tilt) the sample holder with a constant angular velocity in a range of 0.1°/s to 100°/s, in particular 1°/s to 30°/s, preferably 1°/s to 6°/s.

In general, the rotation stage may comprise a rotational actuator which is configured to generate the rotational movement for tilting (rotating) the sample holder. Likewise, the first and the second translation stage may comprise a linear actuator for each respective translation axis which is configured to generate a linear movement. The rotational actuator and or the respective linear actuators may comprise, for example, a piezo drive or a servo drive or a liner motor, respectively.

The irradiation unit may be configured for use in a cryogenic diffractometer. That is, the irradiation unit may be a cryogenic irradiation unit. For this, the irradiation unit may comprise a cryogenic cooling source which is in thermal contact with the sample holder via the manipulator. To this extent, the entire manipulator may also be denoted as cryogenic manipulator. Advantageously, this allows recording diffraction patterns while the sample is at a cryogenic temperature, for example below -150 °C. At such temperatures, the lifetime of the sample within the harsh environment of the irradiation unit (high level of irradiation and/or vacuum) is much larger. **In** particular, the cryogenic cooling source may comprise an insulating storage vessel, for example a Dewar vessel, which is arranged and configured to hold liquefied gas, for example liquefied nitrogen.

Preferably, the charged-particle source is an electron source for generating an electron beam along the charged-particle beam axis. As compared to x-ray diffraction, the interaction between electrons and the atoms of the crystalline sample is much larger, allowing to observe diffraction patterns of crystals having a diameter of the less than one micrometer down to several nanometers. In addition, when using electrons, the irradiation unit according to the present invention may advantageously implement components and techniques that are well known from electron microscopy, in particular from TEMs. This applies to the charged-particle source as well as to the charged-particle optical system and the charged-particle-optical imaging system. The latter will be described in more detail further below.

Preferably, the electron source is configured to generate an electron beam having an energy in a range of 60 keV to 300 keV, with a tolerance in a range of ±0.7 keV to ±1.5 keV or in range of ± 7eV to ±150 eV. For example, the electron source may be configured to generate an electron beam of 200 keV ±1.2 keV. Preferably, the electron source may be configured to generate an electron beam of 160 keV having a ripple of at most 80 eV peak-to peak, in particular of at most 10eV, more particularly of at most 5 eV. The electron source may be configured to be operated at one or more constant acceleration voltages. Alternatively, the electron source may be configured to generate a beam of electrons having a selectable energy.

Advantageously, the charged-particle-optical system may be configured to manipulate the charged-particle beam such the charged-particle beam irradiated to the sample is a parallel beam of charged-particles having a beam diameter of at most 1.5 µm, in particular of at most 1 µm, preferably at most 0.3 µm, for example, in a range between 0.5 µm and 0.3 µm or in a range between 0.3 µm and 0.15 µm. Preferably, the beam diameter is adapted to the volume of the sample.

Preferably, the charged-particle-optical system may comprise one or more condenser lenses to form the charged-particle beam on the sample. In addition, the charged-particle-optical system may comprise an aperture upstream of the sample to adapt the diameter of the charged-particle beam at the sample position. The charged-particle-optical system may further comprise one or more alignment coils or deflectors, in particular double deflectors or octupole deflectors, to center the charged-particle beam on the beam axis. For example, the charged-particle-optical system may further comprise two double deflectors and three condenser lenses. In general, the charged-particle-optical system may be arranged along the optical axis downstream the charged-particle source.

The present invention further relates to a charged-particle diffractometer comprising a charged-particle irradiation unit according to the present invention and as described herein, wherein the diffractometer may be preferably used for charged-particle crystallography of a crystalline sample, in particular for electron crystallography of a crystalline sample.

In addition to the irradiation unit, the diffractometer may comprise a charged-particle detection system which is configured at least for collecting a diffraction pattern of the sample based on the beam of charged-particles transmitted through the sample.

Preferably, the detection system may comprise an objective lens to form a magnified image of the sample. The detection system may further comprise a projection system, which for example may include two lenses, to form a magnified image of the sample on a detector. The detector may be a fluorescent screen or an electron detector. For example, the detector may be a two-dimensional hybrid pixel detector. As will be described in more detail further below, the charged-particle detection system may preferably be operated in two different modes, a diffraction mode and an imaging mode. In general, the charged-particle detection system may be arranged along the optical axis downstream the sample position.

As used herein, the terms "axis" and "axes", in particular the terms "first/second sample axis", "first/second/third manipulator axis", "rotation axis" and "cylinder axis", are preferably to be understood as a straight axis in the sense of a straight line. Accordingly, a movement along such an axis is to be understood as a rectilinear motion/movement or a movement along or parallel to a straight line. For instance, a movement along the first/second/third manipulator axis is to be understood as a rectilinear motion/movement along or parallel to a straight line.

As used in the specification including the appended claims, the singular forms "a", "an", and "the" include the plural, unless the context explicitly dictates otherwise. When using the term "about" with reference to a particular numerical value or a range of values, this is to be understood in the sense that the particular numerical value referred to in connection with the "about" is included and explicitly disclosed, unless the context clearly dictates otherwise. For example, if a range of "about" numerical value A to "about" numerical value B is disclosed, this is to be understood to include and explicitly disclose a range of numerical value a to numerical value b. Also, whenever features are combined with the term "or", the term "or" is to be understood to also include "and" unless it is evident from the specification that the term "or" must be understood as being exclusive.

### DESCRIPTION OF THE DRAWINGS

Further advantageous aspects of the invention become apparent from the following description of embodiments of the invention with the aid of the drawings, in which:
- Fig. 1: schematically illustrates of a diffractometer comprising a charged-particle irradiation unit according to an exemplary embodiment the present invention; and
- Fig. 2: shows details of the charged-particle irradiation unit used in the diffractometer according to Fig. 1.

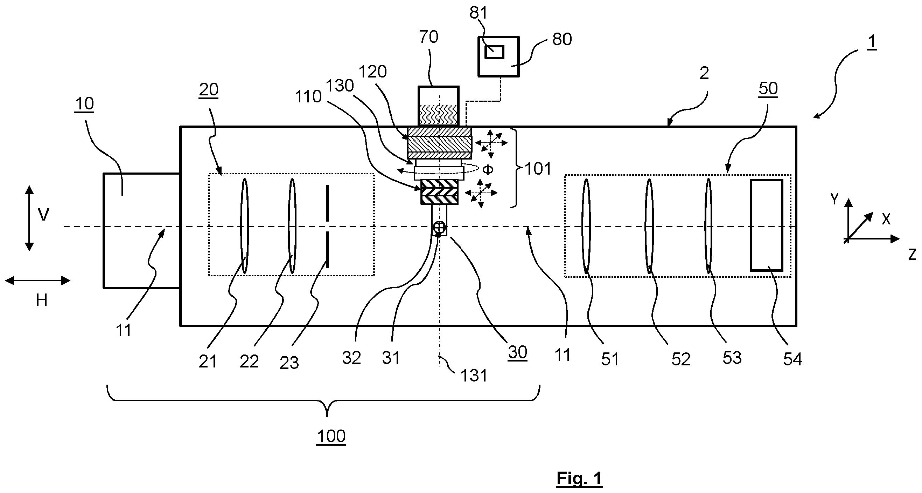

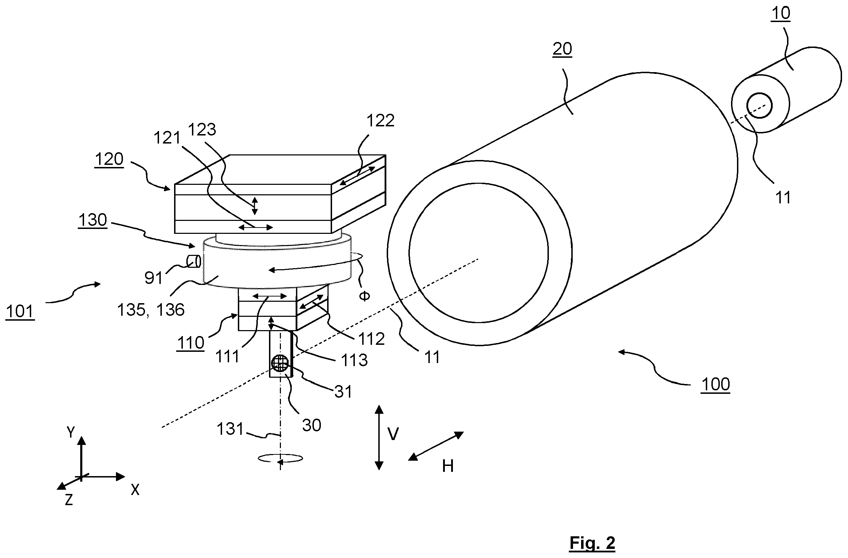

Fig. 1 schematically illustrates a diffractometer 1 suitable for charged-particle crystallography of a crystalline sample 31 which comprises a charged-particle irradiation unit 100 according to an exemplary embodiment of the present invention. Details of the charged-particle irradiation unit 100 are shown in Fig. 2. Both Fig. 1 and Fig. 2 are only schematic illustrations, not to scale.

The diffractometer 1 according to the present embodiment is an electron diffractometer using electrons as charged particles to determine the structure of the crystalline sample 31. Accordingly, the setup of the diffractometer 1 is based on the general setup of an electron microscope, in particular of a transmission electron microscope (TEM), yet having a horizontal beam axis, as will be described in more detail below.

As can be seen in Fig. 1 and Fig. 2, the diffractometer 1 comprises a charged-particle source 10 for generating a beam of electrons along a beam axis 11. The charged-particle source 10 is configured to generate an electron beam of about 200 keV ± 1.2 keV. In contrast to the general setup of standard electron microscopes, which typically comprise a vertical arrangement having the electron beam axis extending vertically downwards, the diffractometer 1 according to the present embodiment comprises a horizontal arrangement having the beam axis 11 extending along a horizontal direction Z.

Downstream the charged-particle source 10, the beam of electrons is manipulated by a charged-particle-optical system 20 such as to form a parallel beam of electrons impinging on the sample 31. For this, the charged-particle-optical system 20 may comprises two condenser lenses 21 and 22 as well as an aperture 23, wherein the diameter of the electron beam at the sample position is governed by the diameter of the aperture 23. The charged-particle-optical system 20 may further comprise alignment coils (not shown) to center the beam of electrons on the beam axis 11. Preferably, the charged-particle-optical system 20 is configured such that the electron beam has a beam diameter of at most 1.5 µm, in particular of at most 1 µm, preferably in a range between 0.5 µm and 0.3 µm at the sample position.

The diffractometer 1 further comprises a charged-particle detection system 50 for collecting a diffraction pattern of the sample 31 based on the beam of electrons transmitted through the sample 31. The detection system 50 is arranged along the optical axis 11 downstream the sample position. In the present embodiment, the detection system 50 comprises an objective lens 51 which may form a magnified image of the sample 31. The detection system 50 further comprises a projection system including two lenses 52 and 53 which may form a magnified image of the sample on a detector 54. The detector 54 may be a fluorescent screen or an electron detector. In particular, the detector 54 may be a direct electron detector, for example as available from DETRICS Ltd. (e.g. DECTRIS QUADRO detector, number of pixels 514 x 514, pixel size 75 µm x 75 µm, maximum frame rate, 18'000 frames/sec., energy range 30-300 keV).

In principle, the charged-particle detection system 50 may be operated in two different modes, a diffraction mode and an imaging mode. In the diffraction mode, the sample is irradiated, preferably with a parallel beam of charged particles. As a result of this, a diffraction pattern is formed in the back-focal plane of the objective lens 51. The projection lenses 52 and 53 are arranged such as to form an enlarged image of the back-focal plane on the image plane of the detector 54. In the imaging mode, the sample may be irradiated in a similar manner as in the diffraction mode. However, in this mode, the projection lenses 52 and 53 do not image the back-focal plane of the objective lens 51 on the imaging plane as in the diffraction mode, but the sample plane on the imaging plane. In the imaging mode, an image of the sample 31 is formed by intensity radiation resulting from charged particles being absorbed in the sample 31 and charged particles diffracted in the sample 31 interfering with charged particles passing the sample unhindered.

For holding the sample 31, the irradiation unit 100 of the diffractometer 1 comprises a sample holder 30. Typically, the sample 31 is mounted on a grid 32, which in turn is mounted on the sample holder 30. The grid 32 may be, for example, a copper grid, having a diameter of about 3 mm and a mesh size of 50 µm, as typically used for crystallographic probes.

The sample holder 30 is operatively coupled to a manipulator 101 which allows for positioning the sample 31 relative to the beam axis 11 in various degrees of freedom.

According to the present invention, the manipulator 101 comprises a rotation stage 130 for rotating the sample holder 30 with respect to the incident charged-particle beam around a rotation axis 131 over different rotational positions Φ. Rotating (tilting) of the sample 31 is used to perform a procedure often denoted as electron diffraction tomography which aims at reconstructing a three-dimensional electron diffraction data set of the sample from a tilt series of diffraction patterns which are acquired by irradiating the sample 31 at different tilt angles (different rotational positions Φ) and by collecting the scattered and non-scattered electrons transmitted through the sample 31 for each tilt angle. As can be seen in Fig. 1 and Fig. 2, the rotation axis 131 extends in a substantially vertical direction V. Due to this, any gravitational effects on the rotation axis 131, the sample holder 30 and the sample 31 are the same for each rotational position Φ. Advantageously, this facilitates to reduce gravitation-induced variations of the rotation axis 131 orientation between different rotational positions Φ. In order to avoid or minimize a collision of the incident charged-particle beam with the sample holder 30, the rotation stage 130 preferably is configured to rotate the sample holder 30 over an angular range between +70° and -70°, in particular between +250° and -70° or between -250° and +70°. The given angular ranges are measured with regard to a reference plane which contains the beam axis 11 and which is parallel to the rotation axis 131. Furthermore, the rotation stage 130 preferably is configured to tilt the sample holder 30 with a constant angular velocity in a range of 0.1°/s to 100°/s, in particular 1°/s to 30°/s. Advantageously, this allows for taking an electron diffraction tomogram in a continuous tilt mode, for example, as described in Nannenga et al., Nature Methods, Vol. 11, No. 9, September 2014. Preferably, the rotation stage 130 is configured to determine the actual rotational position Φ itself. For example, the rotation stage 130 may comprise an encoder for determining its actual rotational position Φ.

As can be further seen in Fig. 1 and Fig, 2, the manipulator 101 is arranged vertically above the sample holder 30 with the rotation axis 131 extending in a substantially vertical direction V. Due to this, any gravitational effects on the rotation axis 131, the sample holder 30 and the sample 31 are the same for each rotational position Φ. Advantageously, this reduces gravitation-induced variations of the rotation axis orientation between different rotational positions Φ and, thus, improves the positional stability of the sample holder 30 over the entire rotation angle range.

A stable positioning of the sample 31 relative to the charged-particle beam over the different rotational positions Φ is essential, in particular in order to ensure that the volume of the sample 31 substantially stays within the charged-particle beam when rotating the sample 31 through different rotational positions Φ.

According to the present invention, this is achieved on the one hand by avoiding an off-centric arrangement of the sample 31 with respect to the rotation axis 131 and on the other hand by providing the possibility to compensate a possible native deviation of the rotation axis 131 from a position of a nominal reference rotation axis of the rotation stage 130 which may occur due to manufacturing tolerances to varying degrees at different rotational positions Φ of the rotation stage 130.

In order to achieve an on-axis arrangement of the sample 31 with respect to the rotation axis 131, the manipulator 101 according to the present invention comprises a first translation stage 110 which is configured to move the sample holder 30 at least along a first sample axis 111 and a second sample axis 112 in a plane perpendicular to the rotation axis 131 and which is operatively coupled between the sample holder 30 and the rotation stage 130 such that the first translation stage 110 is in a rotational system of the rotation stage 130 and the sample holder 30 is in a moving system of the first translation stage 110. Advantageously, this configuration enables to properly position the center of mass of the sample 31 on-axis with the rotation axis 131 such that the sample volume substantially stays within the beam over different rotational positions Φ. In particular, this configuration allows to align the center of mass of the sample 31 to the rotation axis 131 only once, instead of re-aligning the sample 31 almost each time the rotational position Φ is changed. To align the sample 31 on-axis, 31 with respect to the rotation axis 131, the sample 31 may be iteratively imaged at different rotational positions Φ and displaced within the plane perpendicular to the rotation axis 131 until the images show that the position of the center of mass of the sample 31 substantially does not change anymore, i.e. is substantially for the stable when rotating the rotation stage 130 through the different rotational positions Φ. Imaging of the sample may be either accomplished by using the imaging mode of the diffractometer 1 or by using a camera system (not show) that is configured and arranged to image the sample 31 on the sample holder 30.

In addition to the movement in the plane perpendicular to the rotation axis 131 along the first and second sample axes 111, 112, the first translation stage 110 in the present embodiment is further configured move the sample holder 30 along a third sample axis 113 perpendicular to the first sample axis 111 and perpendicular to the second sample axis 112. Advantageously, this further enhances the possibility to correctly align the sample 31 with the charged particle beam, in particular to adjust the sample 31 in the vertical direction V.

In general, the above mentioned native deviations of the effective rotation axis 131 may include lateral horizontal offsets perpendicular to the beam axis 11 (see X direction as indicated in Fig. 1 and Fig. 2), parallel offsets in the vertical direction (vertical travel, see Y direction as indicated in Fig. 1 and Fig. 2), lateral offsets along the beam axis 11 (see Z direction as indicated in Fig. 1 and Fig. 2) and inclinations of the effective rotation axis 131 relative to the vertical direction V. According to the present invention, it has been further found that lateral horizontal offsets perpendicular to the beam axis 11 have a major effect on the position accuracy of the sample 31 relative to the charged-particle beam, while the other deviations are less severe. Accordingly, it has been found that it may be sufficient to compensate mainly lateral offsets of the effective rotation axis in a direction perpendicular to the beam axis 11 and perpendicular to the rotation axis 131. For this, the manipulator 101 comprises a second translation stage 120 which is configured to move the rotation stage 130, the sample holder 30 as well as the first translation stage 120 at least along a first manipulator axis 121 that is perpendicular to the beam axis 11 and perpendicular to the rotation axis 131.

As shown in Fig. 1 and Fig. 2, the manipulator 101 of the present embodiment is also configured to move the rotation stage 130, the sample holder 30, and the first translation stage 110 along a second manipulator axis 122 that is perpendicular to the beam axis 11 and perpendicular to the first manipulator axis 121, as well as along a third manipulator axis 123 substantially parallel to the beam axis 11. Hence, the manipulator 101 of the present embodiment is generally capable of compensating deviations in the other degree of freedoms.

For controlling the movement of the rotation stage 130, the first translation stage 110 and the second translation stage 120, the irradiation unit 100 further comprises a controller 80 that is arranged outside the sample chamber 2 and operatively coupled to the manipulator 101 (see Fig. 1). Advantageously, the controller 80 enables an automatic and remote control of the sample positioning.

In particular, the controller 80 is configured to control movement of the second translation stage 120 at least along the first manipulator axis 121 based on a measured or pre-determined native deviation of the rotation axis 131 in order to compensate for different rotational positions of the rotation stage 130 the respective native deviation of the rotation axis 131 from the position of the nominal reference rotation axis at least in a direction that is perpendicular to the beam axis 11 and perpendicular to the vertical direction V. in addition to the movement along the first manipulator axis 121, the controller 80 generally is also configured to control movement of the second translation stage 120 along the second manipulator axis 122 and possibly along the third manipulator axis 123) based on the measured pre-determined native deviation of the rotation axis 131, such as to compensate the respective native deviation of the rotation axis 131 at least in a plane perpendicular to the beam axis 11, or even in all dimensions.

As described above, the native deviation of the rotation axis 131 may be either pre-determined or measured. In the first case, the controller 80 may comprise a storage 81 for storing the respective pre-determined native deviation for different rotational positions Φ. In particular, the pre-determined native deviations may be stored in the form of a lookup table which contains for each axis, in particular for the first manipulator axis 121 and preferably also for the second manipulator axis 122 and the third manipulator axis 123, the respective native deviations of the rotation axis along these axes for different rotational positions Φ. The respective values of the deviations along the different axes for different rotational positions may be used as converted control signals to be sent to the second translation stage 120 which are indicative of the respective movement (displacement/shift) of the various manipulator axes, that are required for the actually given rotational position Φ to compensate the respective deviation of the rotation axis 131 at the given rotational position Φ.

In the present embodiment, the irradiation unit 100 is also configured to provide a deviation compensation based on measured deviations. For this, the irradiation unit 100 comprises a measurement device 90 with a least a first sensor 91 capable of measuring the respective native deviation of the rotation axis 131 for different rotational positions Φ of the rotation stage 130 in a direction that is perpendicular to the beam axis 11 and perpendicular to the vertical direction V, that is, along the first manipulator axis 121 (see Fig. 2). In addition, the measurement device 90 may also comprise sensors (not shown) capable of measuring the respective native deviation of the rotation axis 131 for different rotational positions Φ in a direction perpendicular to the beam axis 11 and perpendicular to the first manipulator axis 121, that is, along the second manipulator axis 122, as well as in a direction substantially parallel to the beam axis 11, that is, along the third manipulator axis 123.

In order to allow a measurement of the deviations, the rotation stage 130 as shown in Fig. 2 comprises a cylindrical reference body 135 that is attached to the rotating part of the rotation stage 130. An outer surface of the cylindrical reference body 135 defines a cylindrical reference surface 136, which is aligned substantially coaxial with the rotation axis 131. A position of a cylinder axis of the cylindrical reference surface 136 at a pre-defined rotational reference position of the rotation stage 131 may define the position of the nominal reference rotation axis. Since the cylindrical reference surface 136 is itself rotationally symmetric, any position deviation of the cylindrical reference surface 136 from its position at the pre-defined rotational reference position (besides invariant rotational position changes), in particular a lateral shift in the horizontal plane X-Z and/or inclinations relative to vertical direction possibly occurring when rotating to a rotational position other than the pre-defined rotational reference position, directly indicates that the rotation axis 131 deviates from the position of the nominal reference rotation axis. Such position deviations of the cylindrical reference surface 136 may be quantitatively measured, for example, by capacitive position sensors, such as the sensor 91 shown in Fig. 2, which measures a deviation of the cylindrical reference surface 136 from its position at the pre-defined rotational reference position along the first manipulator axis 121. Preferably, there is provided at least one sensor to measure a change in position of the cylindrical reference surface 136 in a direction along each of the three manipulator axes 121, 122, 123. The sensors may be configured to generate a signal indicative of the respective measured native deviation of the rotation axis from the position of the nominal reference rotation axis along each of the three manipulator axes 121, 122, 123, which is subsequently used by the controller 80 to correct the position of the rotation stage 130 along at least the first manipulator axis 121, and preferably also along the second and the third manipulator axes 122, 123.

As shown in Fig. 1, the sample holder 30 and thus the sample 31 are arranged within a sample chamber 2 of the diffractometer 1. The sample chamber 2 also contains the charged-particle-optical system 20 as well as the charged-particle detection system 50 and the manipulator 101. Typically, the sample chamber 2 is under vacuum conditions to suppress undesired interaction of the electron beam with any matter other than the sample 31.

To increase the lifetime of the sample 31, the diffractometer 1 according to the present embodiment further comprises a cryogenic cooling source 70 which is in thermal contact with the sample holder 30 via the manipulator 101. The cryogenic cooling source 70 comprises a cup-like insulating storage vessel, for example a Dewar vessel, used to hold liquefied gas, for example liquefied nitrogen, to cool the sample holder 31 and the sample 30 down to cryogenic temperatures, e.g. below -150 °C.

## Claims

1. A charged-particle irradiation unit (100) for a charged-particle diffractometer, the irradiation unit (100) comprising:
- a charged-particle source (10) for generating a charged-particle beam along a charged-particle beam axis (11), the beam axis (11) extending in a substantially horizontal direction (H);
- a charged-particle-optical system (20) for manipulating the charged-particle beam such as to irradiate a sample (31) with the charged-particle beam;
- a sample holder (30) for holding the sample (31),
- a manipulator (101) operatively coupled to the sample holder (30) for positioning the sample (31) relative to the beam axis (11), wherein the manipulator (101) comprises:
- a rotation stage (130) for rotating the sample holder (30) with respect to the incident charged-particle beam around a rotation axis (131) over different rotational positions (Φ), the rotation axis (131) extending in a substantially vertical direction (V),
- a first translation stage (110) configured to move the sample holder (30) at least along a first sample axis (111) and a second sample axis (112) in a plane substantially perpendicular to the rotation axis (131), wherein first translation stage (110) is operatively coupled between the sample holder (30) and the rotation stage (130) such that the first translation stage (110) is in a rotational system of the rotation stage (130) and the sample holder (30) is in a moving system of the first translation stage (110), thereby enabling to position the center of mass of the sample (31) substantially on-axis with regard to the rotation axis (131); and
- a second translation stage (120) configured to move the rotation stage (130), the sample holder (30) and the first translation stage (110) at least along a first manipulator axis (121) that is perpendicular to the beam axis (11) and perpendicular to the vertical direction (V), wherein the rotation stage (130) is operatively coupled between the second translation stage (120) and the first translation stage (110) such that the rotation stage (130) is in a moving system of the second translation stage (120), thereby enabling to compensate for different rotational positions (Φ) of the rotation stage (130) a respective measured or pre-determined native deviation of the rotation axis (131) from a position of a nominal reference rotation axis of the rotation stage (130) at least in a direction that is perpendicular to the beam axis (11) and perpendicular to the vertical direction (V).

2. The irradiation unit (100) according to claim 1, wherein the second translation stage (120) is further configured to move the rotation stage (130), the sample holder (30) and the first translation stage (110) along a second manipulator axis (122) that is perpendicular to the beam axis (11) and perpendicular to the first manipulator axis (121).

3. The irradiation unit (100) according to any one of claim 1 or claim 2, wherein the second translation stage (120) is further configured to move the rotation stage (130), the sample holder (30) and the first translation stage (110) along a third manipulator axis (123) substantially parallel to the beam axis (11).

4. The irradiation unit (100) according to any one of the preceding claims, wherein the irradiation unit (100) comprises a controller (80) operatively coupled to the manipulator (101) to control movement of the rotation stage (130), the first translation stage (110) and the second translation stage (120).

5. The irradiation unit (100) according to claim 4, wherein the controller (80) is configured to control movement of the second translation stage (120) along at least the first manipulator axis (121) based on the measured or pre-determined native deviation of the rotation axis (131) such as to compensate for different rotational positions (Φ) of the rotation stage (130) the respective native deviation of the rotation axis (131) from the position of the nominal reference rotation axis at least in a direction that is perpendicular to the beam axis (11) and perpendicular to the vertical direction (V).

6. The irradiation unit (100) according to any one of claim 4 or claim 5, wherein the controller (80) is further configured to control movement of the second translation stage (120) along the second manipulator axis (122).

7. The irradiation unit (100) according to any one of claims 4 to 6, wherein the controller (80) is further configured to control movement of the second translation stage (120) along the third manipulator axis (123).

8. The irradiation unit (100) according to any one of the preceding claims, wherein the rotation stage (130) is configured to determine the rotational position (Φ) of the rotation stage (130), in particular wherein the rotation stage (130) comprises an encoder for determining the rotational position (Φ) of the rotation stage (130).

9. The irradiation unit (100) according to claim 8, wherein the controller (80) is operatively coupled to the rotation stage (130) to receive the determined rotational position (Φ) of the rotation stage (130).

10. The irradiation unit (100) according to any one of claims 4 to 9, wherein the controller (80) comprises a storage (81) for storing the respective pre-determined native deviation of the rotation axis (131) for different rotational positions (Φ) of the rotation stage (130).

11. The irradiation unit (100) according to any one of the preceding claims, wherein the irradiation unit (100) comprises a measurement device, in particular a measurement device including one or more capacitive position sensors or an interferometric measurement device, for measuring for different, in particular for each rotational position (Φ) of the rotation stage (130) the respective native deviation of the rotation axis (131) from the position of the nominal reference rotation axis at least in a direction that is perpendicular to the beam axis (11) and perpendicular to the vertical direction (V).

12. The irradiation unit (100) according to claim 11, wherein the controller (80) is operatively coupled the measurement device to receive the respective measured native deviation of the rotation axis (131) from the position of the nominal reference rotation axis.

13. The irradiation unit (100) according to any one of the preceding claims, wherein the rotation stage (130) comprises a cylindrical reference surface (136) aligned substantially coaxial with the rotation axis (131), wherein a position of a cylinder axis of the cylindrical reference surface (136) at a pre-defined rotational reference position of the rotation stage (130) defines the position of the nominal reference rotation axis.

14. The irradiation unit (100) according to claim 13, wherein the rotation stage (130) comprises a cylindrical reference body (134) aligned substantially coaxial with the rotation axis (131), wherein an outer surface of the cylindrical reference body (134) defines the cylindrical reference surface (136).

15. The irradiation unit (100) according to any one of the preceding claims, wherein the irradiation unit (100) comprises a cryogenic cooling source (70) which is in thermal contact with the sample holder (30) via the manipulator (101).

## Patentansprüche

1. Geladene-Teilchen-Bestrahlungseinheit (100) für ein Geladene-Teilchen-Diffraktometer, wobei die Geladene-Teilchen-Bestrahlungseinheit (100) umfasst:
- eine Geladene-Teilchen-Quelle (10) zum Erzeugen eines Geladene-TeilchenStrahls entlang einer Geladene-Teilchen-Strahlachse (11), wobei sich die Strahlachse (11) in einer im Wesentlichen horizontalen Richtung (H) erstreckt;
- ein Geladene-Teilchen-Optiksystem (20) zum Manipulieren des Geladene-Teilchen-Strahls, um eine Probe (31) mit dem Geladene-Teilchen-Strahl zu bestrahlen;
- einen Probenhalter (30) zum Halten der Probe (31),
- einen Manipulator (101), der operativ mit dem Probenhalter (30) gekoppelt ist, um die Probe (31) relativ zur Strahlachse (11) zu positionieren, wobei der Manipulator (101) Folgendes aufweist:
- eine Rotationsstufe (130) zum Drehen des Probenhalters (30) in Bezug auf den einfallenden Geladene-Teilchen-Strahl um eine Rotationsachse (131) über verschiedene Rotationspositionen (Φ), wobei sich die Rotationsachse (131) in einer im Wesentlichen vertikalen Richtung (V) erstreckt,
- eine erste Translationsstufe (110), die so konfiguriert ist, dass sie den Probenhalter (30) zumindest entlang einer ersten Probenachse (111) und einer zweiten Probenachse (112) in einer Ebene bewegt, die im Wesentlichen senkrecht zur Rotationsachse (131) steht, wobei die erste Translationsstufe (110) operativ zwischen dem Probenhalter (30) und der Rotationsstufe (130) gekoppelt ist, sodass die erste Translationsstufe (110) in einem Rotationssystem der Rotationsstufe (130) und der Probenhalter (30) in einem Bewegungssystem der ersten Translationsstufe (110) angeordnet ist, wodurch es ermöglicht wird, den Schwerpunkt der Probe (31) im Wesentlichen auf der Achse in Bezug auf die Rotationsachse (131) zu positionieren; und
- eine zweite Translationsstufe (120), die so konfiguriert ist, dass sie die Rotationsstufe (130), den Probenhalter (30) und die erste Translationsstufe (110) zumindest entlang einer ersten Manipulatorachse (121) bewegt, die senkrecht zur Strahlachse (11) und senkrecht zur vertikalen Richtung (V) ist, wobei die Rotationsstufe (130) operativ zwischen der zweiten Translationsstufe (120) und der ersten Translationsstufe (110) gekoppelt ist, derart dass sich die Rotationsstufe (130) in einem Bewegungssystem der zweiten Translationsstufe (120) befindet, wodurch es ermöglicht wird, unterschiedliche Rotationspositionen (Φ) der Rotationsstufe (130) um eine jeweilige gemessene oder vorbestimmte native Abweichung der Rotationsachse (131) von einer Position einer nominalen Referenzrotationsachse der Rotationsstufe (130) zumindest in einer Richtung zu kompensieren, die senkrecht zur Strahlachse (11) und senkrecht zur vertikalen Richtung (V) ist.

2. Geladene-Teilchen-Bestrahlungseinheit (100) nach Anspruch 1, wobei die zweite Translationsstufe (120) ferner so konfiguriert ist, dass sie die Rotationsstufe (130), den Probenhalter (30) und die erste Translationsstufe (110) entlang einer zweiten Manipulatorachse (122) bewegt, die senkrecht zur Strahlachse (11) und senkrecht zur ersten Manipulatorachse (121) ist.

3. Geladene-Teilchen-Bestrahlungseinheit (100) nach einem der Ansprüche 1 oder 2, wobei die zweite Translationsstufe (120) ferner so konfiguriert ist, dass sie die Rotationsstufe (130), den Probenhalter (30) und die erste Translationsstufe (110) entlang einer dritten Manipulatorachse (123) bewegt, die im Wesentlichen parallel zur Strahlachse (11) verläuft.

4. Geladene-Teilchen-Bestrahlungseinheit (100) nach einem der vorangegangenen Ansprüche, wobei die Geladene-Teilchen-Bestrahlungseinheit (100) eine Steuereinheit (80) umfasst, die operativ mit dem Manipulator (101) gekoppelt ist, um ein Bewegung der Rotationsstufe (130), der ersten Translationsstufe (110) und der zweiten Translationsstufe (120) zu steuern.

5. Geladene-Teilchen-Bestrahlungseinheit (100) nach Anspruch 4, wobei die Steuereinheit (80) so konfiguriert ist, dass sie die Bewegung der zweiten Translationsstufen (120) entlang mindestens der ersten Manipulatorachse (121) auf Basis der gemessenen oder vorbestimmten nativen Abweichung der Rotationsachse (131) so steuert, um für unterschiedliche Rotationspositionen (Φ) der Rotationsstufe (130) die jeweilige native Abweichung der Rotationsachse (131) von der Position der nominalen Referenzrotationsachse zumindest in einer Richtung, die senkrecht zur Strahlachse (11) und senkrecht zur vertikalen Richtung (V) ist, zu kompensieren.

6. Geladene-Teilchen-Bestrahlungseinheit (100) nach einem der Ansprüche 4 oder 5, wobei die Steuereinheit (80) ferner so konfiguriert ist, dass sie die Bewegung der zweiten Translationsstufe (120) entlang der zweiten Manipulatorachse (122) steuert.

7. Geladene-Teilchen-Bestrahlungseinheit (100) nach einem der Ansprüche 4 bis 6, wobei die Steuereinheit (80) ferner so konfiguriert ist, dass sie die Bewegung der zweiten Translationsstufe (120) entlang der dritten Manipulatorachse (123) steuert.

8. Geladene-Teilchen-Bestrahlungseinheit (100) nach einem der vorangegangenen Ansprüche, wobei die Rotationsstufe (130) so konfiguriert ist, dass sie die Rotationsposition (Φ) der Rotationsstufe (130) bestimmt, insbesondere wobei die Rotationsstufe (130) einen Encoder zum Bestimmen der Rotationsposition (Φ) der Rotationsstufe (130) umfasst.

9. Geladene-Teilchen-Bestrahlungseinheit (100) nach Anspruch 8, wobei die Steuereinheit (80) operativ mit der Rotationsstufe (130) gekoppelt ist, um die bestimmte Rotationsposition (Φ) der Rotationsstufe (130) zu empfangen.

10. Geladene-Teilchen-Bestrahlungseinheit (100) nach einem der Ansprüche 4 bis 9, wobei die Steuereinheit (80) einen Speicher (81) zum Speichern der jeweiligen vorbestimmten native Abweichung der Rotationsachse (131) für verschiedene Rotationspositionen (Φ) der Rotationsachse (130) umfasst.

11. Geladene-Teilchen-Bestrahlungseinheit (100) nach einem der vorangegangenen Ansprüche, wobei die Geladene-Teilchen-Bestrahlungseinheit (100) eine Messvorrichtung umfasst, insbesondere eine Messvorrichtung mit einem oder mehreren kapazitiven Positionssensoren oder eine interferometrische Messvorrichtung, um für verschiedene, insbesondere für jede Rotationsposition (Φ) der Rotationsstufe (130) die jeweilige native Abweichung der Rotationsachse (131) von der Position der nominalen Referenzrotationsachse zumindest in einer Richtung, die senkrecht zur Strahlachse (11) und senkrecht zur Vertikalrichtung (V) ist, zu messen.

12. Geladene-Teilchen-Bestrahlungseinheit (100) nach Anspruch 11, wobei die Steuereinheit (80) operativ mit der Messvorrichtung gekoppelt ist, um die jeweilige gemessene native Abweichung der Rotationsachse (131) von der Position der nominalen Referenzrotationsachse zu empfangen.

13. Geladene-Teilchen-Bestrahlungseinheit (100) nach einem der vorstehenden Ansprüche, wobei die Rotationsstufe (130) eine zylindrische Referenzfläche (136) umfasst, die im Wesentlichen koaxial zur Rotationsachse (131) ausgerichtet ist, wobei eine Position einer Zylinderachse der zylindrischen Referenzfläche (136) an einer vordefinierten Rotationsreferenzposition der Rotationsstufe (130) die Position der nominalen Referenzrotationsachse definiert.

14. Geladene-Teilchen-Bestrahlungseinheit (100) nach Anspruch 13, wobei die Rotationsstufe (130) einen zylindrische Referenzkörper (134) umfasst, der im Wesentlichen koaxial zur Rotationsachse (131) ausgerichtet ist, wobei eine Aussenfläche des zylindrischen Referenzkörpers (134) die zylindrische Referenzfläche (136) definiert.

15. Geladene-Teilchen-Bestrahlungseinheit (100) nach einem der vorstehenden Ansprüche, wobei die Bestrahlungseinheit (100) eine kryogene Kühlquelle (70) umfasst, die über den Manipulator (101) in thermischem Kontakt mit dem Probenhalter (30) steht.

## Revendications

1. Unité d'irradiation (100) de particules chargées pour un diffractomètre de particules chargées, l'unité d'irradiation (100) comprenant :
- une source (10) de particules chargées pour générer un faisceau de particules chargées le long d'un axe de faisceau (11) de particules chargées, l'axe de faisceau (11) s'étendant dans une direction sensiblement horizontale (H) ;
- un système optique (20) à particules chargées pour manipuler le faisceau de particules chargées de manière à irradier un échantillon (31) avec le faisceau de particules chargées ;
- un porte-échantillon (30) pour soutenir l'échantillon (31),
- un manipulateur (101) couplé de manière opérationnelle au porte-échantillon (30) pour positionner l'échantillon (31) par rapport à l'axe de faisceau (11), dans laquelle le manipulateur (101) comprend :
- un étage de rotation (130) pour faire tourner le porte-échantillon (30) par rapport au faisceau de particules chargées incident autour d'un axe de rotation (131) sur différentes positions de rotation (Φ), l'axe de rotation (131) s'étendant dans une direction sensiblement verticale (V),
- un premier étage de translation (110) configuré pour déplacer le porte-échantillon (30) au moins le long d'un premier axe d'échantillon (111) et d'un second axe d'échantillon (112) dans un plan sensiblement perpendiculaire à l'axe de rotation (131), dans laquelle le premier étage de translation (110) est couplé de manière opérationnelle entre le porte-échantillon (30) et l'étage de rotation (130), de sorte que le premier étage de translation (110) se trouve dans un système de rotation de l'étage de rotation (130) et que le porte-échantillon (30) se trouve dans un système de déplacement du premier étage de translation (110), permettant ainsi de positionner le centre de masse de l'échantillon (31) sensiblement sur l'axe en ce qui concerne l'axe de rotation (131) ; et
- un second étage de translation (120) configuré pour déplacer l'étage de rotation (130), le porte-échantillon (30) et le premier étage de translation (110) au moins le long d'un premier axe de manipulateur (121) qui est perpendiculaire à l'axe de faisceau (11) et perpendiculaire à la direction verticale (V), dans laquelle l'étage de rotation (130) est couplé de manière opérationnelle entre le second étage de translation (120) et le premier étage de translation (110), de sorte que l'étage de rotation (130) se trouve dans un système de déplacement du second étage de translation (120), permettant ainsi de compenser pour différentes positions de rotation (Φ) de l'étage de rotation (130) un écart natif mesuré ou prédéterminé respectif de l'axe de rotation (131) par rapport à une position d'un axe de rotation de référence nominal de l'étage de rotation (130), au moins dans une direction qui est perpendiculaire à l'axe de faisceau (11) et perpendiculaire à la direction verticale (V).

2. Unité d'irradiation (100) selon la revendication 1, dans laquelle le second étage de translation (120) est en outre configuré pour déplacer l'étage de rotation (130), le porte-échantillon (30) et le premier étage de translation (110) le long d'un deuxième axe de manipulateur (122) qui est perpendiculaire à l'axe de faisceau (11) et perpendiculaire au premier axe de manipulateur (121).

3. Unité d'irradiation (100) selon l'une quelconque de la revendication 1 ou de la revendication 2, dans laquelle le second étage de translation (120) est en outre configuré pour déplacer l'étage de rotation (130), le porte-échantillon (30) et le premier étage de translation (110) le long d'un troisième axe de manipulateur (123) sensiblement parallèle à l'axe de faisceau (11).

4. Unité d'irradiation (100) selon l'une quelconque des revendications précédentes, dans laquelle l'unité d'irradiation (100) comprend un dispositif de commande (80) couplé de manière opérationnelle au manipulateur (101) pour commander un mouvement de l'étage de rotation (130), du premier étage de translation (110) et du second étage de translation (120).

5. Unité d'irradiation (100) selon la revendication 4, dans laquelle le dispositif de commande (80) est configuré pour commander un mouvement du second étage de translation (120) le long d'au moins le premier axe de manipulateur (121) sur la base de l'écart natif mesuré ou prédéterminé de l'axe de rotation (131) de manière à compenser pour différentes positions de rotation (Φ) de l'étage de rotation (130) l'écart natif respectif de l'axe de rotation (131) par rapport à la position de l'axe de rotation de référence nominal au moins dans une direction qui est perpendiculaire à l'axe de faisceau (11) et perpendiculaire à la direction verticale (V).

6. Unité d'irradiation (100) selon l'une quelconque de la revendications 4 ou de la revendication 5, dans laquelle le dispositif de commande (80) est en outre configuré pour commander un mouvement du second étage de translation (120) le long du deuxième axe de manipulateur (122).

7. Unité d'irradiation (100) selon l'une quelconque des revendications 4 à 6, dans laquelle le dispositif de commande (80) est en outre configuré pour commander un mouvement du second étage de translation (120) le long du troisième axe de manipulateur (123).

8. Unité d'irradiation (100) selon l'une quelconque des revendications précédentes, dans laquelle l'étage de rotation (130) est configuré pour déterminer la position de rotation (Φ) de l'étage de rotation (130), en particulier dans laquelle l'étage de rotation (130) comprend un codeur pour déterminer la position de rotation (Φ) de l'étage de rotation (130).

9. Unité d'irradiation (100) selon la revendication 8, dans laquelle le dispositif de commande (80) est couplé de manière opérationnelle à l'étage de rotation (130) pour recevoir la position de rotation déterminée (Φ) de l'étage de rotation (130).

10. Unité d'irradiation (100) selon l'une quelconque des revendications 4 à 9, dans laquelle le dispositif de commande (80) comprend un stockage (81) pour stocker l'écart natif prédéterminé respectif de l'axe de rotation (131) pour différentes positions de rotation (Φ) de l'étage de rotation (130).

11. Unité d'irradiation (100) selon l'une quelconque des revendications précédentes, dans laquelle l'unité d'irradiation (100) comprend un dispositif de mesure, en particulier un dispositif de mesure comportant un ou plusieurs capteurs de position capacitifs ou un dispositif de mesure interférométrique, pour mesurer, pour différentes positions, en particulier pour chaque position de rotation (Φ) de l'étage de rotation (130), l'écart natif respectif de l'axe de rotation (131) par rapport à la position de l'axe de rotation de référence nominal, au moins dans une direction qui est perpendiculaire à l'axe de faisceau (11) et perpendiculaire à la direction verticale (V).

12. Unité d'irradiation (100) selon la revendication 11, dans laquelle le dispositif de commande (80) est couplé de manière opérationnelle au dispositif de mesure pour recevoir l'écart natif mesuré respectif de l'axe de rotation (131) par rapport à la position de l'axe de rotation de référence nominal.

13. Unité d'irradiation (100) selon l'une quelconque des revendications précédentes, dans laquelle l'étage de rotation (130) comprend une surface de référence cylindrique (136) alignée de manière sensiblement coaxiale avec l'axe de rotation (131), dans laquelle une position d'un axe de cylindre de la surface de référence cylindrique (136) à une position de référence de rotation prédéfinie de l'étage de rotation (130) définit la position de l'axe de rotation de référence nominal.

14. Unité d'irradiation (100) selon la revendication 13, dans laquelle l'étage de rotation (130) comprend un corps de référence cylindrique (134) aligné de manière sensiblement coaxiale avec l'axe de rotation (131), dans laquelle une surface externe du corps de référence cylindrique (134) définit la surface de référence cylindrique (136).

15. Unité d'irradiation (100) selon l'une quelconque des revendications précédentes, dans laquelle l'unité d'irradiation (100) comprend une source de refroidissement cryogénique (70) qui est en contact thermique avec le porte-échantillon (30) via le manipulateur (101).
